(19)

Europäisches
Patentamt
European
Patent Office
Office européen
des brevets

(11) **EP 2 333 808 A1**

(12) **EUROPEAN PATENT APPLICATION**

(43) Date of publication:
**15.06.2011 Bulletin 2011/24**

(51) Int Cl.:
*H01J 37/05* (2006.01)     *H01J 37/10* (2006.01)
*H01J 37/147* (2006.01)

(21) Application number: **09178967.7**

(22) Date of filing: **11.12.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **ICT Integrated Circuit Testing Gesellschaft für Halbleiterprüftechnik mbH
85551 Heimstetten (DE)**

(72) Inventor: **Frosien, Juergen
85521 Riemerling (DE)**

(74) Representative: **Zimmermann & Partner
Postfach 330 920
80069 München (DE)**

(54) **Charged particle beam device, method of operating a charged particle beam device**

(57)     A charged particle beam device is provided, including a primary beam source for generating a primary charged particle beam, an objective lens for focusing the primary charged particle beam onto a specimen, and an achromatic beam separator adapted to separate the primary charged particle beam from a secondary charged particle beam originating from the specimen. The achromatic beam separator is adapted to separate the primary charged particle beam and the secondary charged particle beam earliest practicable after generation of the secondary charged particle beam.

FIG 3

**Description**

TECHNICAL FIELD

The present invention relates to a charged particle beam device, and a method of operating a charged particle beam device. Further, embodiments relate to a charged particle beam device including an achromatic beam separator.

BACKGROUND ART

Semiconductor technologies have created a high demand for structuring and probing specimens within the nanometer scale. Micrometer and nanometer scale process control, inspection or structuring, is often done with charged particle beams. Probing or structuring is often performed with charged particle beams which are generated and focused in charged particle beam devices. Examples of charged particle beam devices are electron microscopes, electron beam pattern generators, ion microscopes as well as ion beam pattern generators. Charged particle beams, in particular electron beams, offer superior spatial resolution compared to photon beams, due to their short wavelengths at comparable particle energy.

Particle optics apparatuses like, e.g. Scanning Electron Microscopes (SEM), generate a primary beam illuminating or scanning a specimen. In such particle beam systems fine probes with high current density can be used. For instance in case of an SEM, the primary electron (PE) beam generates particles like secondary electrons (SE) and/or backscattered electrons (BSE) that can be used to image and analyze the specimen. Many instruments use either electrostatic or compound electric-magnetic lenses to focus the primary beam onto the specimen. In some cases, the electrostatic field of the lens simultaneously collects the generated particles (SE and BSE) which are entering into the lens and must be guided onto a detector. If uniform high efficiency electron collection and detection is required, the secondary and/or backscattered particles must be separated from the primary beam. In such a case, the detection configuration can be designed completely independent from the PE optics design.

In all these configurations, an optimized beam separator design which does not impact PE optical performance is desired. Therefore, an achromatic beam separator has been proposed. Additionally, in high current density systems, a boundary condition is that the probe size is not enlarged by electron electron interaction which blurs the PE beam. Reduction of electron-electron interaction can for instance be achieved by: a short optical column to minimize electron-electron interaction probability, and high beam energy inside the column and deceleration to final beam energy just close to the specimen.

SUMMARY

In light of the above, a charged particle beam device according to claim 1, a method of operating a charge particle beam device according to claim 9, and a use according to claim 15 are provided.

In one embodiment, a charged particle beam device is provided, including a primary beam source for generating a primary charged particle beam, an objective lens for focusing the primary charged particle beam onto a specimen, and an achromatic beam separator adapted to separate the primary charged particle beam from a secondary charged particle beam originating from the specimen. The achromatic beam separator is adapted to separate the primary charged particle beam and the secondary charged particle beam earliest practicable after generation of the secondary charged particle beam.

According to a further embodiment, a method of operating a charged particle beam device includes: emitting a primary charged particle beam from a primary beam source; focusing the primary charged particle beam onto a specimen by an objective lens; generating a secondary charged particle beam originating from the specimen; and magnetically deflecting the primary charged particle beam and the secondary charged particle beam earliest practicable after generation of the secondary charged particle beam.

In another embodiment, a charged particle beam device according to above one embodiment can be used in a method of probing and/or structuring of a specimen.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

Fig. 1 schematically illustrates a charged particle beam device;

Fig. 2 schematically shows an example of an achromatic beam separator of embodiments;

Fig. 3 schematically illustrates a part of a charged particle beam device according to embodiments;

Fig. 4 schematically illustrates a part of a charged particle beam device according to embodiments;

Fig. 5 schematically illustrates a part of a charged particle beam device according to embodiments;

Fig. 6 schematically illustrates a part of a charged particle beam device according to embodiments;

Fig. 7 schematically illustrates a part of a charged particle beam device according to embodiments; and

Fig. 8 schematically illustrates a part of a charged particle beam device according to embodiments.

It is contemplated that elements of one embodiment may be advantageously utilized in other embodiments without further recitation.

DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope of protection, in the following description the charged particle beam device or components thereof will exemplarily be referred to as a charged particle beam device including the detection of secondary electrons. Embodiments described herein can still be applied for apparatuses and components detecting corpuscles such as secondary and/or backscattered charged particles in the form of electrons or ions, photons, X-rays or other signals in order to obtain a specimen image.

Generally, when referring to corpuscles it is to be understood as particles or charged particles, in which the corpuscles are ions, atoms, electrons or other particles. Further, in the following, the term "secondary charged particles" includes secondary charged particles created at or in the specimen, and backscattered charged particles. In case of a primary electron beam, the term "secondary electrons" includes secondary electrons (SE), e.g. Auger electrons, and backscattered electrons (BSE).

Further, without limiting the scope, in the following the examples and embodiments of the achromatic beam separator device are described referring to an SEM. Typically, the devices of embodiments described herein include vacuum-compatible materials. Typical applications of embodiments described herein are for example probing and/or structuring of a specimen in solar wafer manufacturing and in semiconductor device production.

Within embodiments, the term "electric field" can be also referred to as electrostatic field or electrostatic deflection field, and the term "magnetic field" can be also referred to as magnetic deflection field.

A "specimen" as referred to herein, includes, but is not limited to, semiconductor wafers, semiconductor workpieces, and other workpieces such as memory disks and the like. Embodiments may be applied to any workpiece on which material is deposited, which is inspected or which is structured. A specimen includes a surface to be structured, imaged or on which layers are deposited.

Within the following description of the drawings, the same reference numbers refer to the same components. Generally, only the differences with respect to the individual embodiments are described.

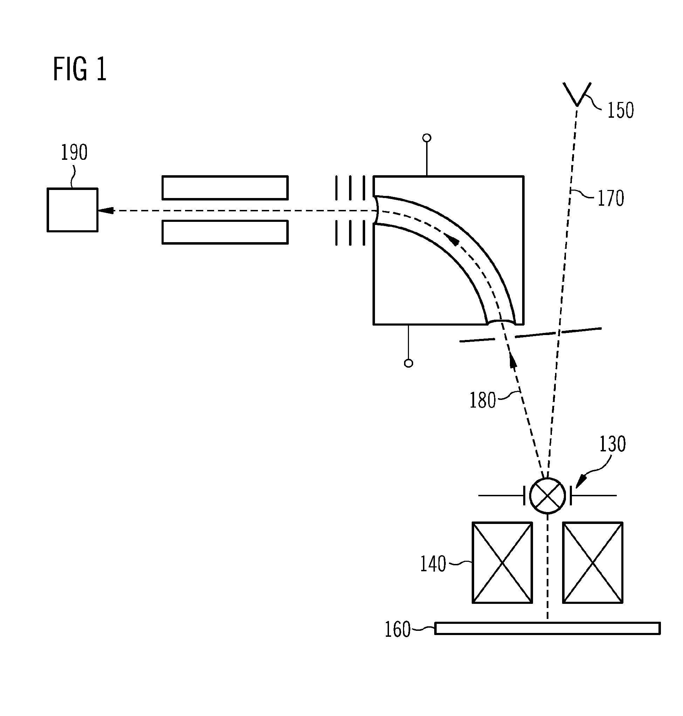

A typical setup of an achromatic beam separator 130 in an electron microscope is shown in Fig. 1. The achromatic beam separator 130 is arranged in front of an objective lens 140. A primary electron beam 170 produced by an emitter 150 enters the beam separator 130 under an angle, is deflected to the objective lens axis, impinges on a specimen 160 and generates secondary electrons, also called herein signal electrons. The secondary electron (SE) beam is extracted into the lens 140, transverses the separator 130 and is deflected to the side, forming a separated SE bundle 180 that travels towards a detector 190.

According to embodiments, which can be combined with any of the embodiments described herein, an achromatic beam separator 130 having an electric field generating element and a magnetic field generating element can be provided. Achromatic beam separators use magnetic and electric fields in a configuration in which the magnetic deflection field strength is twice as large as the electrostatic deflection field strength and in which the force of the magnetic deflection field acts in a direction opposite to the direction in which the force of the electrostatic field acts. An achromatic beam separator having superimposed electrostatic and magnetic fields can be called a Wien filter type configuration, such as the setup of the achromatic beam separator 130 shown in Fig. 1. Alternatively, an achromatic beam separator may have sequential magnetic and electrostatic field arrangements.

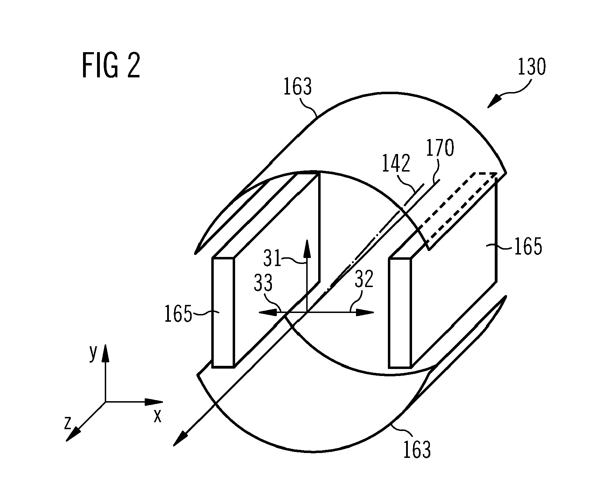

Figure 2 shows an enlarged view of an embodiment of the achromatic beam separator 130 of Fig. 1, also called herein achromatic separator, beam splitter or beam separator. Substantially perpendicular static electric and magnetic fields normal to the z-axis 142, also referred to herein as objective lens optical axis, are used. The force acting on the electrons is given by the coulomb force

$$F_e = q \cdot E \qquad (1)$$

and the Lorentz force

$$F_m = q \cdot (v \times B) \qquad (2)$$

The angle of deflection of the electrons in the electric and magnetic fields, both of length 1, can be described with the following equation:

$$\theta = ql(vB - E)/(mv^2) \qquad (3)$$

Fig. 2 illustrates the achromatic beam separator 130. Therein, coil windings 163 and plate-shaped electrodes 165 are shown. The coils 163 generate a magnetic field 31. The magnetic field generates a magnetic force 32 for an electron beam 170. The magnetic force is generated according to equation 2. Substantially perpendicular to the magnetic field 31 an electric field is generated between the electrodes 165. Thereby, an electric force 33, which is substantially opposite to the magnetic force, is generated.

The embodiment shown in Fig. 2 generates perpendicular magnetic and electric fields. Within Fig. 2, the path of electron beam 170 is inclined with respect to the axis 142 when the electrons enter the achromatic deflector. The electrons are deflected within the achromatic deflector to travel essentially along the z-axis 142 after trespassing the achromatic deflector. This can be understood in light of the derivative of equation 3, that is

$$d\theta / dv = -(qlB / mv^2)(1 - 2E / vB) \qquad (4)$$

The deflection angle is independent of the velocity of the electrons, if the condition that the magnetic force equals twice the electric force is fulfilled. In Fig. 2 this is illustrated by the lengths of the force indicating arrows 32 and 33.

In embodiments described herein, the achromatic beam separator 130 can be described at least by one of the following features. According to one embodiment, 20 to 100 ampere turns (Aturns), e.g. 50 Aturnes, may be provided, even for applications under increased column voltage or increased deflection angle. According to an even further embodiment, about 10 to 400 coil windings can be provided. Yet according to another embodiment, 50 to 500 coil windings can be provided. Nevertheless, it might be possible to provide even more coil windings, for example, up to a few thousand. Other important parameters are for instance the geometry of the coils, if present the iron core, the beam energy inside the deflector 130 or separator 130, or the deflection angle.

According to an even further embodiment, the achromatic deflection angle can be between about 1 ° and about 25° for a coarse range. According to another further embodiment, the deflection angle is between about 2° and about 5° for a narrow range.

In the achromatic beam separator shown in figure 2, electrostatic deflection is given by:

$$\alpha_e \propto \frac{E_{\perp}}{U_A}, U_A \rightarrow U_A + \Delta U_A \Rightarrow \delta\alpha \propto -\Delta U_A$$

Further, magnetic deflection is given by:

$$\alpha_m \propto \frac{B_{\perp}}{\sqrt{U_A}}, U_A \rightarrow U_A + \Delta U_A \Rightarrow \delta\alpha \propto -\frac{1}{2}\Delta U_A$$

If the magnetic deflection equals minus two times the electrostatic deflection, a deflection without chromatic aberration (dispersion) can be realized.

The orthogonal electric and magnetic dipole fields of the beam separator, respectively, are usually generated by devices having a minimum number of pole pieces or excitation coils. By design, the fields can be shaped, such that for instance parasitic hexapole fields can be avoided, e.g. by using 120° saddle coils or by an appropriate shaping of electrodes. In one embodiment, which can be combined with other embodiments described herein, a 60° angle of saddle coils can reduce or avoid hexapole components. Further, alternatively, a combination of coils with a 42° and 78° angle can reduce or avoid hexapole and decapole components.

In charged particle beam systems utilizing high probe (primary beam) currents and high probe current densities, the effect of primary particle-secondary particle interaction on primary beam performance has been previously not considered. Since high primary beam currents also generate high secondary beam currents, those can interfere with the primary beam and influence the primary beam spot performance. For instance, in electron beam systems wherein detection is performed after the secondary electron beam has passed the objective lens, the primary beam and the secondary beam travel in opposite directions on a collision course and may affect each other a considerably long time. This can limit the primary beam spot diameter in high resolution, high probe current systems.

In one embodiment, a charged particle beam device is provided, including a primary beam source for generating a primary charged particle beam, an objective lens for focusing the primary charged particle beam onto a specimen, and an achromatic beam separator adapted to separate the primary charged particle beam and a secondary charged particle beam originating from the specimen. The achromatic beam separator can be adapted to separate the primary charged particle beam and the secondary charged particle beam earliest, earliest practicable or earliest possible after generation of the secondary charged particle beam. In embodiments, the achromatic beam separator can be adapted to magnetically deflect the primary charged particle beam and the secondary charged particle beam earliest practicable or earliest possible after generation of the secondary charged particle beam. The achromatic beam separator can be adapted to separate the primary charged particle beam and the secondary charged particle beam at the earliest practicable moment and/or location after generation of the secondary charged particle beam. In embodiments, the secondary charged particle beam can be separated from the primary charged particle beam at a location nearest possible or nearest practicable to the origin of the secondary charged particle beam or to the specimen.

In some embodiments, the magnetic field generating element is adapted and/or positioned to generate a magnetic field adjacent to or in the vicinity of the origin of the secondary charged particle beam, e.g. the specimen. In embodiments, the objective lens has a center, a backside facing the primary beam source, and a back focal length directed towards a back focal plane. According to embodiments, the achromatic beam separator includes a magnetic field generating element adapted to generate a magnetic field and an electric field generating element adapted to generate an electric field. In embodiments, the magnetic field generating element can be adapted and/or positioned to generate a magnetic field in a position between the origin of the secondary charged particle beam and a location at a distance of tenfold the back focal length from the center of the objective lens. In embodiments, the magnetic field generating element can be adapted and/or positioned to generate a magnetic field in a position between the origin of the secondary charged particle beam and at least one element chosen from: the center of the objective lens, a location within the objective lens, and the back focal plane of the objective lens. In embodiments, the magnetic field generating element can be adapted and/or positioned to generate a magnetic field in a position within the objective lens.

In a further embodiment, the charged particle beam device of embodiments can be used in a method of probing and/or structuring of a specimen.

According to one embodiment, a method of operating a charged particle beam device includes: emitting a primary charged particle beam from a primary beam source; focusing the primary charged particle beam onto a specimen by an objective lens; generating a secondary charged particle beam originating from the specimen; and magnetically deflecting the primary charged particle beam and the secondary charged particle beam earliest, earliest practicable or earliest possible after generation of the secondary charged particle beam. The objective lens may have a center, a backside facing the primary beam source, and a back focal length directed towards the backside. The primary charged particle beam and the secondary charged particle beam can be magnetically deflected in a position between the specimen and a location at a distance of tenfold the back focal length from the center of the objective lens. In embodiments, the magnetic field can be generated in a position between the origin of the secondary charged particle beam and at least one element chosen from: the center of the objective lens, a location within the objective lens, and the back focal plane of the objective lens. In embodiments, the magnetic field can be generated in a position within the objective lens.

Embodiments described herein allow for a minimization of interactions and/or collisions of secondary charged particles with primary charged particles during operation of a charged particle beam device. Therefore, the achievable current density in high resolution charged particle beam systems can be increased and blurring of the primary charged particle beam can be avoided.

According to embodiments, the charged particle beam device is operated using a beam boost potential, which means that the primary charged particle beam energy is high inside of the column and is decelerated to a final energy within the objective lens or between the objective lens and the specimen. Final beam energies are typically in the range of about 100 eV to 10 keV, more typically about 100 eV to 5 keV.

According to embodiments, in case of an achromatic beam separator having a Wien filter arrangement and/or an arrangement generating overlapping magnetic and electric fields, the beam separator can be positioned as close as possible to the source of the secondary charged particles emission, e.g. the specimen. When short focal length objective lenses are used and the space between objective lens and the specimen is substantially small, the beam separator having generating overlapping electric and magnetic fields can be positioned inside of the objective lens, for instance at the center of the objective lens, or at the back focal plane of the objective lens. Alternatively, the beam separator generating overlapping electric and magnetic fields can be positioned at a distance less than tenfold the back focal length from the center of the objective lens.

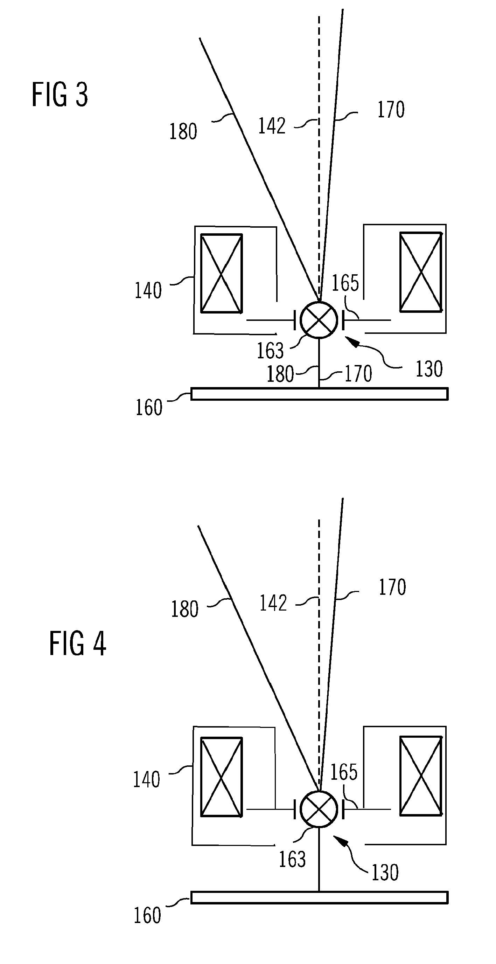

Fig. 3 schematically illustrates a specimen side part of a charged particle beam device according to an embodiment. This embodiment differs from the electron beam device of Fig. 1 in that the achromatic beam separator 130 is positioned within the objective lens at the specimen side beam aperture of the objective lens 140. Thereby, the primary electron beam propagating on the primary optical axis is deflected in the beam separator 130 onto the objective lens optical axis 142 and towards the specimen 160. The secondary electron beam 180 emitted from the specimen (not shown) travels at least partially into the objective lens 140 and is deflected by the beam separator 130. Thereby, the secondary electron beam 180 is already separated from the primary electron beam 170 at the specimen side beam aperture of the objective lens, such that collisions and interactions of electrons travelling in opposite directions are reduced.

Fig. 4 schematically shows the specimen side part of another embodiment of a charged particle beam device. According to the present embodiment, the achromatic beam separator 130 is positioned within the objective lens near the center of the objective lens 140. Consequently, a minimization of an interaction and/or collision of secondary electrons with primary electrons is achieved as compared to the electron microscope shown in Fig.1.

According to embodiments, in case of an achromatic beam separator generating electric and magnetic fields in an sequential arrangement along the z-axis, the magnetic field generating element of the beam separator and/or the generated magnetic field can be positioned as close as possible to the specimen surface. Thereby, since the magnetic field deflects the secondary charged particles and the primary charged particles in opposite directions, the separation of the primary and secondary charged particles is achieved close to the specimen. Hence, when the charged particle beam device is operated, the time available for interaction of the secondary and primary charged particles is minimized. For instance, the magnetic field generating element of the achromatic beam separator can be positioned inside of the objective lens, e.g. at the center of the objective lens, or at the back focal plane of the objective lens. Alternatively, the magnetic field generating element can be positioned at a distance less than tenfold the back focal length from the center of the objective lens.

In some embodiments, the electric field generating element of the beam separator and/or the generated electric field can be positioned, in propagation direction of the secondary charged particle beam, subsequent to the magnetic field generating element and/or the magnetic field, for instance between the magnetic field and the primary beam source. The electric field deflects the secondary charged particle beam and the primary charged particle beam into the same direction. Hence, during operation of the charged particle beam device, the deflection into opposite directions is performed previous to the deflection into the same direction. Therefore, the separation of the primary charged particles and the secondary charged particles is achieved subsequent to the emission of the secondary charged particles and before they are deflected into the same direction. Consequently, during operation of the charged particle beam device, the time available for interactions of the secondary and primary charged particles is minimized.

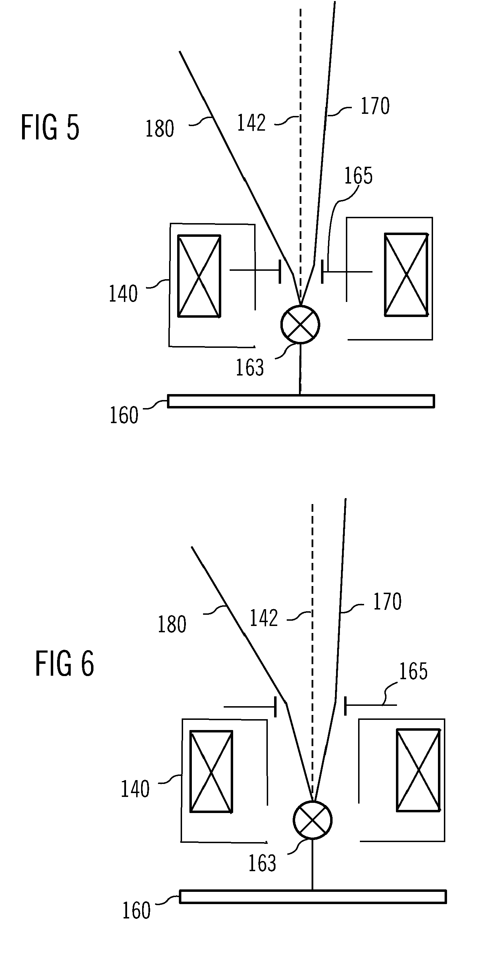

Fig. 5 schematically illustrates an achromatic beam separator generating electric and magnetic fields in a sequential arrangement along the z-axis, according to an embodiment. The beam separator includes the coils 163 as the magnetic field generating element and the electrodes 165 as the electric field generating element. The coils 163 are positioned within the objective lens 140 at the specimen side beam aperture thereof. The electrodes 165 are located within the objective lens near or at the center thereof, i.e. in propagation direction of the secondary electron beam 180 subsequent to the coils 163. As a result, the secondary electron beam 180 is already separated from the primary electron beam 170 at the specimen side beam aperture of the objective lens, such that electron-electron collisions and interactions are reduced.

Fig. 6 schematically shows another embodiment of an achromatic beam separator which generates electric and magnetic fields in a sequential arrangement along the z-axis 142. This embodiment differs from the embodiment of Fig. 5 in that the electrodes 165 are positioned outside of the objective lens and at the objective lens aperture which faces the primary beam source. Again, the secondary electron beam 180 is already separated from the primary electron beam 170 at the specimen side beam aperture of the objective lens, such that collisions and interactions of electrons travelling in the primary and secondary beams in opposite directions are minimized.

In some embodiments, the achromatic beam separator includes a further magnetic field generating element adapted to generate a further magnetic field, and the further magnetic field generating element is adapted and/or positioned to generate the further magnetic field between the objective lens and the primary charged particle beam source. Thereby, the incidence angle of the primary charged particle beam into the objective lens and/or the beam separator, the emergent angle of the secondary charged particle beam out of the objective lens and/or the beam separator, and, as a result, the separation and/or angle between the two particle beams can be tailored.

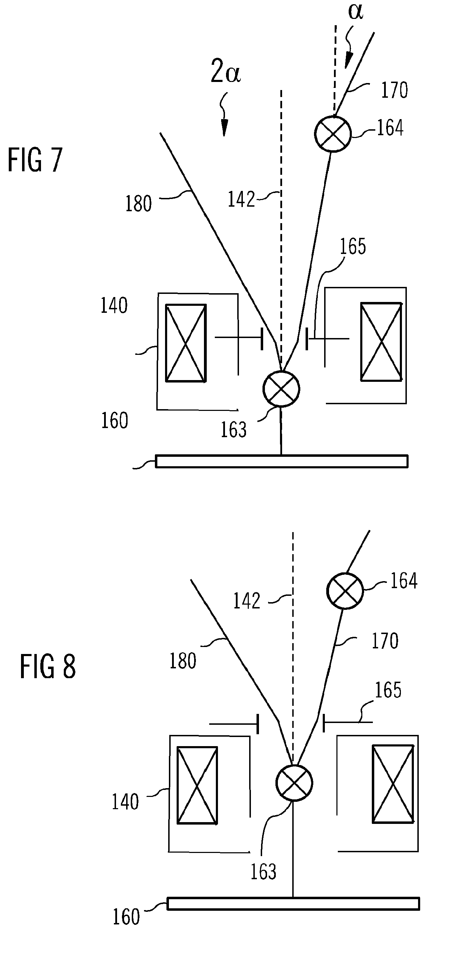

Hence, according to embodiments, a part of the magnetic field, e.g. 50 % of the magnetic field, can be located only within the path of the primary beam. Therefore, the secondary charged particle beam does not pass all deflection fields on its way to the detector. As a consequence, the spatial angular separation of the primary charged particle beam and the secondary charged particle beam is not as in the embodiments shown in e.g. Figs. 3 to 6. $\alpha$ is the angle between the primary charged particle beam 170 as emitted by the primary beam source and the corresponding vertical axis. The angle of the secondary charged particles relative to the corresponding vertical axis is $3\alpha$ for all systems in which the secondary charged particles pass all deflection fields. Hence, in the embodiments shown in e.g. Figs. 3 to 6, the spatial angular separation of the primary charged particle beam and the secondary charged particle beam is $4\alpha$. For arrangements, in which the secondary charged particle beam does not pass all deflection fields, the angle of the secondary charged particles beam relative to the vertical axis is smaller than $3\alpha$. For instance, according to the embodiments shown in Figs. 7 and 8, the angle of the secondary charged particles beam relative to the vertical axis is $2\alpha$. Hence, the primary charged particle beam and the secondary charged particle beam have a separation of $3\alpha$.

Fig. 7 illustrates schematically an embodiment of an achromatic beam separator which generates electric and magnetic fields in a sequential arrangement along the z-axis 142. In this embodiment, the beam separator includes additional coils 164 as compared to the embodiment of Fig. 5. The coils 164 are positioned at the primary optical axis in the path of the primary electron beam 170. Hence, the primary electron beam 170 emitted by the primary beam source at angle $\alpha$ is deflected at coils 164. The coils 164 generate a part of the magnetic field of the beam separator. For instance, about 50 % of the magnetic field can be generated by the coils 164 and the rest of the magnetic field can be generated using the coils 163. For example, the coils 163 and 164 create a magnetic field having in total a strength corresponding to the field of the embodiments shown in Figs. 3 to 5 including only coils 163. As a result, in the present example, the secondary electrons are not affected by the magnetic field of the coils 164 and experience just 50 % of the magnetic field as compared to the embodiments of Figs. 3 to 5. Consequently, the primary electron beam 170 and the secondary electron particle beam 180 have a separation of $3\alpha$. According to the present embodiment, the secondary electron beam 180 is already separated from the primary electron beam 170 at the specimen side beam aperture of the objective lens, such that electron-electron interactions are reduced.

Fig. 8 schematically illustrates a further embodiment, in which the electric and magnetic fields are generated in a sequential arrangement along the z-axis 142. The beam separator additionally includes the coils 164 like in the embodiment of Fig. 7, which are positioned such that the secondary electrons are not affected by the additional coils 164. The coils 163 are located at the center of the objective lens and the electrodes 165 are positioned outside of the objective lens and at the objective lens aperture which faces the primary beam source. According to the present embodiment, during operation the secondary electron beam 180 is already separated from the primary electron beam 170 at the center of the objective lens 140 and before being deflected by the electrodes 165, such that electron-electron collisions or interactions are reduced.

According to embodiments, the electric and magnetic fields can be generated on the objective lens optical axis, e.g. encompassing the axis of the objective lens. In some embodiments, which can be combined with any other embodiment described herein, the incident primary beam or at least a part thereof can have an angle of incidence of less than 90° into the beam inlet of the beam separator device. In some embodiments, the electrical field is provided orthogonal to the magnetic field and/or encompassing the magnetic field. Moreover, according to embodiments, the electric field and the magnetic field can be provided substantially perpendicular to each other and/or substantially normal to the objective lens optical axis. In further embodiments, which can be combined with any other embodiment described herein, the electric field generating element and the magnetic field generating element are adapted to encompass the objective lens optical axis.

In some embodiments, at least one element chosen from the electric field generating element and the magnetic field generating element is adapted, e.g. positioned and/or positionable, adjusted and/or adjustable, and/or controlled and/or controllable, to compensate an aberration of the charged particle beam device, e.g. an octopole influence. For instance, at least one element chosen from the magnetic field generating element and the electric field generating element is positioned and/or positionable to create a trajectory of a primary charged particle beam bundle that allows the primary charged particle beam to experience an equal amount of positive and negative octopole effect about the axis of the achromatic beam separator. Examples of such arrangements are described in applications EP 09173111 and US 12/579869, which are incorporated herein by reference. Thereby, the net effect of the octopole on the primary charged particle beam is substantially zero. The octopole can be an octopole potential and/or an octopole field.

According to one embodiment, a charged particle beam device is provided, including a primary beam source for generating a primary charged particle beam, an objective lens for focusing the primary charged particle beam onto a specimen, and an achromatic beam separator adapted to separate the primary charged particle beam from a secondary charged particle beam originating from the specimen. The achromatic beam separator is adapted to separate the primary charged particle beam and the secondary charged particle beam earliest practicable or earliest possible after generation of the secondary charged particle beam.

In some embodiments, which can be combined with any other embodiment described herein, the objective lens has a center, a backside facing the primary beam source, and a back focal length directed towards a back focal plane. The achromatic beam separator may include a magnetic field generating element adapted to generate a magnetic field and an electric field generating element adapted to generate an electric field. The magnetic field generating element can be adapted and/or positioned to generate a magnetic field in a position between the origin of the secondary charged particle beam and a location at a distance of tenfold the back focal length from the center of the objective lens.

According to embodiments, which can be combined with any other embodiment described herein, the electric field generating element can be adapted and/or positioned to generate the electric field in a position chosen from: a position overlapping the magnetic field; and a position between the magnetic field and the primary charged particle beam source.

In some embodiments, which can be combined with any other embodiment described herein, the objective lens can be a short front focal length objective lens. The magnetic field generating element can be adapted and/or positioned to generate the magnetic field in a position located in a region extending from within the objective lens to the location at a distance of tenfold the back focal length from the center of the objective lens.

In some embodiments, which can be combined with any other embodiment described herein, the primary beam source defines a primary optical axis, the objective lens defines an objective lens optical axis, and the achromatic beam separator defines a secondary optical axis; the primary optical axis and the objective lens optical axis can be identical, or the primary optical axis can be inclined with regard to the objective lens optical axis.

In some embodiments, which can be combined with any other embodiment described herein, the magnetic field generating element and the electric field generating element can be adapted and/or positioned to generate overlapping magnetic and electric fields in at least one position chosen from: a position within the objective lens; a position at the center of the objective lens; and a position at the back focal plane of the objective lens. In some embodiments, which can be combined with any other embodiment described herein, the electric field generating element is adapted and/or positioned to generate the electric field between the magnetic field and the primary charged particle beam source and wherein the magnetic field is generated in at least one position chosen from: a position within the objective lens; a position at the center of the objective lens; and a position at the back focal plane of the objective lens.

In some embodiments, which can be combined with any other embodiment described herein, the achromatic beam separator includes a further magnetic field generating element adapted to generate a further magnetic field, and the further magnetic field generating element is adapted and/or positioned to generate the further magnetic field between the objective lens and the primary charged particle beam source. The achromatic beam separator may be adapted to generate the magnetic field and/or the further magnetic field substantially perpendicular to the electric field. The achromatic beam separator can be adapted to generate the strength of the magnetic field or the strength of the sum of the magnetic field and the further magnetic field twice as large as the strength of the electric field. In embodiments, which can be combined with any other embodiment described herein, at least one element chosen from the magnetic field generating element and the electric field generating element can be adapted, positioned and/or positionable to compensate an aberration of the charged particle beam device.

In some embodiments, which can be combined with any other embodiment described herein, primary beam accelerating and/or decelerating means are included, which are adapted to accelerate the primary charged particle beam between the primary beam source and the objective lens and/or to decelerate the primary charged particle beam to a final energy within the objective lens or between objective lens and the specimen.

In further embodiments, which can be combined with any other embodiment described herein, the charged particle beam device is at least one element chosen from a scanning charged particle beam device, an ion beam device, an electron beam device, an ion beam inspection device, an electron beam inspection device and an SEM.

According to one embodiment, a method of operating a charged particle beam device includes: emitting a primary charged particle beam from a primary beam source; focusing the primary charged particle beam onto a specimen by an objective lens; generating a secondary charged particle beam originating from the specimen; and magnetically deflecting the primary charged particle beam and the secondary charged particle beam earliest practicable after generation of the secondary charged particle beam.

In some embodiments, which can be combined with any other embodiment described herein, the objective lens has a center, a backside facing the primary beam source, and a back focal length directed towards the backside. In some embodiments, which can be combined with any other embodiment described herein, the primary charged particle beam and the secondary charged particle beam are magnetically deflected in a position between the specimen and a location at a distance of tenfold the back focal length from the center of the objective lens.

In some embodiments, which can be combined with any other embodiment described herein, the primary beam source generates the primary charged particle beam on a primary optical axis, and/or the objective lens defines an objective lens optical axis, and/or the achromatic beam separator defines a secondary optical axis on which the secondary charged particle beam is deflected. In some embodiments, which can be combined with any other embodiment described herein, the primary optical axis and the objective lens optical axis are identical, or the primary optical axis is inclined with regard to the objective lens optical axis. In some embodiments, which can be combined with any other embodiment described herein, the method comprises separating the secondary charged particle beam from the primary charged particle beam, wherein the step of magnetically deflecting is included in the separating.

In some embodiments, which can be combined with any other embodiment described herein, the step of magnetically deflecting is performed by generating a magnetic field in the position between the specimen and the location at a distance of tenfold the back focal length from the center of the objective lens. In some embodiments, which can be combined with any other embodiment described herein, the step of magnetically deflecting is performed by deflecting the primary charged particle beam and the secondary charged particle beam into opposite directions.

In some embodiments, which can be combined with any other embodiment described herein, the step of magnetically deflecting and/or the step of separating the secondary charged particle beam from the primary charged particle beam includes at least one step chosen from: generating an electric field and a magnetic field; generating the electric field in a position chosen from a position overlapping the magnetic field and a position between the magnetic field and the primary charged particle beam source; generating the magnetic field in a position located in a region extending from within the objective lens to the location at a distance of tenfold the back focal length from the center of the objective lens, wherein the objective lens is a short front focal length objective lens; generating overlapping magnetic and electric fields in at least one position chosen from: a position within the objective lens, a position at the center of the objective lens, and a position at the back focal plane of the objective lens; generating the electric field between the magnetic field and the primary charged particle beam source and generating the magnetic field in at least one position chosen from: a position within the objective lens, a position at the center of the objective lens, and a position at the back focal plane of the objective lens; generating a further magnetic field between the objective lens and the primary charged particle beam source on the primary optical axis; generating the magnetic field and/or the further magnetic field substantially perpendicular to the electric field; and generating the electric field and the magnetic field such that the strength of the magnetic field or the strength of the sum of the magnetic field and the further magnetic field is twice as large as the strength of the electric field.

In some embodiments of the method of operating the charged particle device, the charged particle beam device is a device according to any embodiment described herein. In some embodiments, which can be combined with any other embodiment described herein, the primary optical axis is inclined with respect to the objective lens optical axis by an angle $\alpha$. In some embodiments, which can be combined with any other embodiment described herein, the primary charged particle beam and the secondary charged particle beam are formed having a separation angle smaller than $4\alpha$. In some embodiments, which can be combined with any other embodiment described herein, the primary charged particle beam is accelerated between the primary beam source and the objective lens and/or decelerated to a final energy within the objective lens or between the objective lens and the specimen. In some embodiments, which can be combined with any other embodiment described herein, at least one element chosen from the magnetic field and the electric field is adapted or is provided in a position to compensate an aberration of the charged particle beam device.

According to a yet further embodiment, a method of probing of a specimen is provided, wherein probing of the specimen is performed using a charged particle beam device according to any embodiment described herein. According to another embodiment, a method of structuring of a specimen is provided, wherein structuring of the specimen is performed using a charged particle beam device according to any embodiment described herein.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

**Claims**

1.  A charged particle beam device, comprising
    a primary beam source for generating a primary charged particle beam;
    an objective lens for focusing the primary charged particle beam onto a specimen; and
    an achromatic beam separator adapted to separate the primary charged particle beam from a secondary charged particle beam originating from the specimen;
    wherein the achromatic beam separator is adapted to separate the primary charged particle beam and the secondary charged particle beam earliest practicable after generation of the secondary charged particle beam.

2.  The device of claim 1,
    wherein the objective lens has a center, a backside facing the primary beam source, and a back focal length directed towards a back focal plane; and/or
    wherein the achromatic beam separator includes a magnetic field generating element adapted to generate a magnetic field and an electric field generating element adapted to generate an electric field; and/or
    wherein the magnetic field generating element is adapted and/or positioned to generate a magnetic field in a position between the origin of the secondary charged particle beam and a location at a distance of tenfold the back focal length from the center of the objective lens.

3.  The device of any of the preceding claims, wherein the electric field generating element is adapted and/or positioned to generate the electric field in a position chosen from:

    a position overlapping the magnetic field; and
    a position between the magnetic field and the primary charged particle beam source.

4.  The device of any of the preceding claims, wherein
    the objective lens is a short front focal length objective lens, and/or the magnetic field generating element is adapted and/or positioned to generate the magnetic field in a position located in a region extending from within the objective lens to the location at a distance of tenfold the back focal length from the center of the objective lens.

5.  The device of any of the preceding claims,
    wherein the primary beam source defines a primary optical axis, the objective lens defines an objective lens optical axis, and the achromatic beam separator defines a secondary optical axis on which the secondary charged particle beam is deflected; and/or
    wherein the primary optical axis and the objective lens optical axis are identical, or wherein the primary optical axis is inclined with regard to the objective lens optical axis.

6.  The device of any of the preceding claims,
    wherein the magnetic field generating element and the electric field generating element are adapted and/or positioned to generate overlapping magnetic and electric fields in at least one position chosen from:

    a position within the objective lens;
    a position at the center of the objective lens; and
    a position at the back focal plane of the objective lens; and/or

    wherein the electric field generating element is adapted and/or positioned to generate the electric field between the magnetic field and the primary charged particle beam source and wherein the magnetic field is generated in at least one position chosen from:

a position within the objective lens;
a position at the center of the objective lens; and
a position at the back focal plane of the objective lens.

7. The device of any of the preceding claims,
wherein the achromatic beam separator includes a further magnetic field generating element adapted to generate a further magnetic field, and the further magnetic field generating element is adapted and/or positioned to generate the further magnetic field between the objective lens and the primary charged particle beam source, and/or
wherein the achromatic beam separator is adapted to generate the magnetic field and/or the further magnetic field substantially perpendicular to the electric field; and/or
wherein the achromatic beam separator is adapted to generate the strength of the magnetic field or the strength of the sum of the magnetic field and the further magnetic field twice as large as the strength of the electric field; and/or
wherein at least one element chosen from the magnetic field generating element and the electric field generating element is adapted, positioned and/or positionable to compensate an aberration of the charged particle beam device.

8. The device of any of the preceding claims,
wherein primary beam accelerating and/or decelerating means are included, which are adapted to accelerate the primary charged particle beam between the primary beam source and the objective lens and/or to decelerate the primary charged particle beam to a final energy within the objective lens or between objective lens and the specimen; and/or
wherein the charged particle beam device is at least one element chosen from a scanning charged particle beam device, an ion beam device, an electron beam device, an ion beam inspection device, an electron beam inspection device and an SEM.

9. A method of operating a charged particle beam device, comprising:

emitting a primary charged particle beam from a primary beam source;
focusing the primary charged particle beam onto a specimen by an objective lens;
generating a secondary charged particle beam originating from the specimen; and
magnetically deflecting the primary charged particle beam and the secondary charged particle beam earliest practicable after generation of the secondary charged particle beam.

10. The method of claim 9,
wherein the objective lens has a center, a backside facing the primary beam source, and a back focal length directed towards the backside; and/or
wherein the primary charged particle beam and the secondary charged particle beam are magnetically deflected in a position between the specimen and a location at a distance of tenfold the back focal length from the center of the objective lens.

11. The method of any of claims 9 to 10,
wherein the primary beam source generates the primary charged particle beam on a primary optical axis, and/or the objective lens defines an objective lens optical axis, and/or the achromatic beam separator defines a secondary optical axis on which the secondary charged particle beam is deflected; and/or
wherein the primary optical axis and the objective lens optical axis are identical, or wherein the primary optical axis is inclined with regard to the objective lens optical axis; and/or
wherein the method comprises separating the secondary charged particle beam from the primary charged particle beam, wherein the step of magnetically deflecting is included in the separating.

12. The method of any of claims 9 to 11, wherein the step of magnetically deflecting is performed by generating a magnetic field in the position between the specimen and the location at a distance of tenfold the back focal length from the center of the objective lens, and/or by deflecting the primary charged particle beam and the secondary charged particle beam into opposite directions.

13. The method of any of claims 9 to 12, wherein the step of magnetically deflecting and/or the step of separating the secondary charged particle beam from the primary charged particle beam includes at least one step chosen from:

generating an electric field and a magnetic field;
generating the electric field in a position chosen from a position overlapping the magnetic field and a position between the magnetic field and the primary charged particle beam source;

generating the magnetic field in a position located in a region extending from within the objective lens to the location at a distance of tenfold the back focal length from the center of the objective lens, wherein the objective lens is a short front focal length objective lens;

generating overlapping magnetic and electric fields in at least one position chosen from: a position within the objective lens, a position at the center of the objective lens, and a position at the back focal plane of the objective lens;

generating the electric field between the magnetic field and the primary charged particle beam source and generating the magnetic field in at least one position chosen from: a position within the objective lens, a position at the center of the objective lens, and a position at the back focal plane of the objective lens;

generating a further magnetic field between the objective lens and the primary charged particle beam source on the primary optical axis;

generating the magnetic field and/or the further magnetic field substantially perpendicular to the electric field; and

generating the electric field and the magnetic field such that the strength of the magnetic field or the strength of the sum of the magnetic field and the further magnetic field is twice as large as the strength of the electric field.

14. The method of any of claims 9 to 13,
wherein the charged particle beam device is a device according to any of claims 1 to 8; and/or
wherein the primary optical axis is inclined with respect to the objective lens optical axis by an angle $\alpha$; and/or
wherein the primary charged particle beam and the secondary charged particle beam are formed having a separation angle smaller than $4\alpha$; and/or
wherein the primary charged particle beam is accelerated between the primary beam source and the objective lens and/or decelerated to a final energy within the objective lens or between the objective lens and the specimen; and/or
wherein at least one element chosen from the magnetic field and the electric field is adapted or is provided in a position to compensate an aberration of the charged particle beam device.

15. Use of a charged particle beam device according to any of claims 1 to 8 in a method of probing and/or structuring of a specimen.

FIG 1

FIG 2

FIG 3

FIG 4

FIG 5

FIG 6

FIG 7

FIG 8

**Europäisches Patentamt**
**European Patent Office**
**Office européen des brevets**

# EUROPEAN SEARCH REPORT

Application Number

EP 09 17 8967

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2008/101713 A2 (APPLIED MATERIALS ISRAEL LTD [IL]; ALMOGY GILAD [IL]; BARTOV AVISHAI []) 28 August 2008 (2008-08-28) | 1,3,5,6, 8-11,14, 15 | INV. H01J37/05 H01J37/10 H01J37/147 |
| Y | * paragraph [0020] * * paragraph [0025] - paragraph [0026]; figures 1,2a,2c,2d * * paragraph [0032] * * paragraph [0046] * * paragraph [0048] * * paragraph [0069] * * paragraph [0082] * | 2,4,7, 12,13 | |
| X | EP 1 100 111 A1 (ADVANTEST CORP [JP]) 16 May 2001 (2001-05-16) | 1-3,5,6, 8-11,14, 15 | |
| Y | * abstract; figures 1,2 * * paragraph [0002] * * paragraph [0004] * * paragraph [0008] * * paragraph [0013] * * paragraph [0024] * | 2,4,7, 12,13 | |
| A | US 2004/075053 A1 (PREIKSZAS DIRK [DE] ET AL) 22 April 2004 (2004-04-22) * abstract; figures 5,6,8,9 * | 1,9 | TECHNICAL FIELDS SEARCHED (IPC) H01J |
| A | US 2006/060790 A1 (NAKASUJI MAMORU [JP] ET AL) 23 March 2006 (2006-03-23) * abstract; figures 4,9 * | 1,9 | |
| A | US 4 362 945 A (RIECKE WOLFGANG D) 7 December 1982 (1982-12-07) * abstract; figures 4-8 * | 1,9 | |
| Y | JP 2005 251440 A (EBARA CORP) 15 September 2005 (2005-09-15) * abstract; figure 1 * | 7,13 | |

-/--

The present search report has been drawn up for all claims

| Place of search | Date of completion of the search | Examiner |
|---|---|---|
| Munich | 28 July 2010 | Rouzier, Brice |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 09 17 8967

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 6 310 341 B1 (TODOKORO HIDEO [JP] ET AL) 30 October 2001 (2001-10-30)<br>* column 4, line 42 - line 44; figure 2 *<br>----- | 7,13 | |
| Y | WO 99/26272 A1 (INTEGRATED CIRCUIT TESTING [DE]; FEUERBAUM HANS PETER [DE]; WINKLER DI) 27 May 1999 (1999-05-27)<br>* page 6, line 24 - line 30; figure 1 *<br>----- | 7,13 | |

TECHNICAL FIELDS
SEARCHED        (IPC)

The present search report has been drawn up for all claims

| Place of search | Date of completion of the search | Examiner |
|---|---|---|
| Munich | 28 July 2010 | Rouzier, Brice |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...........................................................................

& : member of the same patent family, corresponding
    document

EPO FORM 1503 03.82 (P04C01)

Europäisches
Patentamt

European
Patent Office

Office européen
des brevets

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 09 17 8967

The Search Division considers that the present European patent application does not comply with the requirements of unity of invention and relates to several inventions or groups of inventions, namely:

```
1. claims: 1-6, 8-12, 14, 15

        A particular magnetic field generation position.
                        ---

2. claims: 1, 7, 9, 13

        A further magnetic field generating element
                        ---
```

**ANNEX TO THE EUROPEAN SEARCH REPORT
ON EUROPEAN PATENT APPLICATION NO.** EP 09 17 8967

This annex lists the patent family members relating to the patent documents cited in the above-mentioned European search report.
The members are as contained in the European Patent Office EDP file on
The European Patent Office is in no way liable for these particulars which are merely given for the purpose of information.

28-07-2010

| Patent document cited in search report | | Publication date | Patent family member(s) | | Publication date |
|---|---|---|---|---|---|
| WO 2008101713 | A2 | 28-08-2008 | EP | 2132763 A2 | 16-12-2009 |
| | | | EP | 2122655 A2 | 25-11-2009 |
| | | | WO | 2008101714 A2 | 28-08-2008 |
| | | | JP | 2010519697 T | 03-06-2010 |
| | | | JP | 2010519698 T | 03-06-2010 |
| EP 1100111 | A1 | 16-05-2001 | DE | 69903439 D1 | 14-11-2002 |
| | | | DE | 69903439 T2 | 03-07-2003 |
| | | | JP | 2001148227 A | 29-05-2001 |
| | | | US | 6509569 B1 | 21-01-2003 |
| US 2004075053 | A1 | 22-04-2004 | NONE | | |
| US 2006060790 | A1 | 23-03-2006 | NONE | | |
| US 4362945 | A | 07-12-1982 | DE | 2937004 A1 | 19-03-1981 |
| JP 2005251440 | A | 15-09-2005 | NONE | | |
| US 6310341 | B1 | 30-10-2001 | JP | 3441955 B2 | 02-09-2003 |
| | | | JP | 11238484 A | 31-08-1999 |
| WO 9926272 | A1 | 27-05-1999 | EP | 0917177 A1 | 19-05-1999 |

**EP 2 333 808 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 09173111 A
- US 12579869 B